# EUROPEAN PATENT APPLICATION

(11) **EP 4 246 152 A1**
(43) Date of publication of application: **20.09.2023**
(21) Application number: 21893826.4
(22) Date of filing: 12.11.2021
(51) Int. Cl.: G01R 31/00

(54) **VEHICLE DETECTION METHOD, APPARATUS AND DEVICE**

(30) Priority: 23.11.2020 CN 202011324716
(71) Applicant: Autel Intelligent Technology Corp., Ltd., Shenzhen, Guangdong 518055 (CN)
(72) Inventor: ZHONG, Longhui, Shenzhen, Guangdong 518055 (CN); XU, Dongdong, Shenzhen, Guangdong 518055 (CN); LIU, Fuqi, Shenzhen, Guangdong 518055 (CN)
(74) Representative: Gulde & Partner
(86) International application number: PCT/CN2021/130233
(87) International publication number: WO 2022/105679

(57) **Abstract**

Embodiments of the present invention relate to the technical field of vehicle component inspection, and disclose a vehicle inspection method, apparatus and device. The method is applied to a vehicle inspection system comprising an oscilloscope, and the method comprises: acquiring information about a to-be-measured vehicle; acquiring and displaying a measured item associated with information about the to-be-measured vehicle; receiving a user selection operation on the measured item to obtain a selected measured item; acquiring and displaying measurement guidance information corresponding to the selected measured item to prompt a user to connect the vehicle inspection system to the measured item according to the measurement guidance information; and measuring the selected measured item, and displaying a signal waveform corresponding to the measured item when a measurement start instruction of a user is received. In this way, embodiments of the present invention can greatly reduce the threshold for use of a vehicle inspection system including an oscilloscope, improve vehicle inspection efficiency, simplify user operations, and enhance user experience.

## Description

### CROSS-REFERENCE TO RELATED APPLICATIONS

This application claims priority to Chinese Patent Application No. 202011324716. 9, entitled "Vehicle inspection Method, Apparatus and Device", filed on November 23, 2020, by China Patent Office, which is incorporated herein by reference in its entirety.

### TECHNICAL FIELD

The present application relates to the technical field of vehicle component inspection, in particular to a vehicle inspection method, apparatus and device.

### BACKGROUND

With the continuous development of automotive technology, more and more automotive electrical components and more and more complex electrical systems, once a system fails to work, a problem needs to be found first. The measurement of various signals of the system is the key to find the problem, and an oscilloscope is the primary measurement tool. The oscilloscope is a measuring device for inspecting the fault a vehicle electronic circuit, which can measure the signal characteristics such as amplitude, frequency, phase and frequency spectrum. When an oscilloscopes is used, a variety of leads need to be connected to the oscilloscope to a to-be-measured component, however, there are numerous electrical and sensor components in the vehicle, and the measurement of each component may require different leads and connections to enable the oscilloscope to measure a signal of the component.

In implementation of embodiments of the present invention, the inventors have found that: the existing oscilloscope requires a user to connect the oscilloscope with the parts to be measured based on experience, therefore, it is costly to learn to inspect and repair a vehicle using the oscilloscope and it is time-consuming and laborious to measure.

### SUMMARY

In view of the above problems, embodiments of the present invention provide a vehicle inspection method, apparatus and device for solving the problems of high learning cost and time-consuming and laborious measurement using an oscilloscope to inspect and repair a vehicle in the prior art.

According to an aspect of an embodiment of the present invention, provided is A vehicle inspection method, wherein the method is applied to a vehicle inspection system including an oscilloscope; the method includes:
acquiring information about a to-be-measured vehicle;
acquiring and displaying a measured item associated with information about the to-be-measured vehicle;
receiving a user selection operation on the measured item to obtain a selected measured item;
acquiring and displaying measurement guidance information corresponding to the selected measured item to prompt a user to connect the vehicle inspection system to the measured item according to the measurement guidance information; and
measuring the selected measured item, and displaying a signal waveform corresponding to the measured item when a measurement start instruction of a user is received.

In an alternative, the measurement guidance information includes lead connection guidance.

In an alternative, the measurement guidance information further includes at least one of: a measurement purpose, measurement precautions, a measurement start instruction and a measurement guidance diagram.

In an alternative, said measuring the selected measured item, and displaying a signal waveform corresponding to the measured item when a measurement start instruction of a user is received includes:
when a measurement start instruction from a user is received, acquiring parameter configuration data of the selected measured item, calling the oscilloscope to load the parameter configuration data to measure the measured item, acquiring a measurement signal of the measured item and outputting a signal waveform corresponding to the measurement signal, and displaying the signal waveform output by the oscilloscope.

In an alternative, after said displaying a signal waveform corresponding to the measured item, including:
acquiring predetermined measurement result information corresponding to the parameter configuration data; displaying the predetermined measurement result information so that a user compares the signal waveform with the predetermined measurement result information to determine a measurement result.

In an alternative, the vehicle inspection system includes a server; after said displaying a signal waveform corresponding to the measured item, including:
transmitting the signal waveform to the server, so that the server compares the signal waveform with predetermined measurement result information, and determines a measurement result; wherein the predetermined measurement result information is predetermined measurement result information corresponding to the parameter configuration data; and
receiving the measurement result transmitted by the server.

In an alternative, after said displaying a signal waveform corresponding to the measured item, including:
acquiring predetermined measurement result information corresponding to the parameter configuration data; comparing the signal waveform with the predetermined measurement result information to determine a measurement result.

In an alternative, the method includes:
saving user-defined measurement guidance information to a vehicle information database according to a user identifier when the user edits measurement guidance information about the selected measured item to generate the user-defined measurement guidance information;
said acquiring and displaying measurement guidance information corresponding to the selected measured item includes:
acquiring and displaying user-defined measurement guidance information corresponding to the selected measured item from the vehicle information database according to the user identifier.

In an alternative, the method includes:
saving the user-defined parameter configuration data and user-defined predetermined measurement result information to a vehicle information database according to a user identifier when the user edits parameter configuration data of the selected measured item to generate user-defined parameter configuration data, and calls an oscilloscope to load the user-defined parameter configuration data to measure the selected measured item to generate user-defined predetermined measurement result information;
said acquiring parameter configuration data of the selected measured item includes:
acquiring user-defined parameter configuration data of the selected measured item from the vehicle information database according to the user identifier;
the predetermined measurement result information includes the user-defined predetermined measurement result information corresponding to the identification of the user.

According to another aspect of an embodiment of the present invention, provided is an inspection apparatus applied to an inspection system including an oscilloscope; the apparatus including:
a first acquisition module for acquiring information about a to-be-measured vehicle;
a second acquisition module for acquiring and displaying a measured item associated with the information about the to-be-measured vehicle;
a receiving module for receiving a user selection operation on the measured item to obtain a selected measured item;
a third acquisition module for acquiring and displaying measurement guidance information corresponding to the selected measured item to prompt a user to connect the vehicle inspection system to the measured item according to the measurement guidance information; and
a display module for measuring the selected measured item, and displaying a signal waveform corresponding to the measured item when a measurement start instruction of a user is received.

According to yet another aspect of an embodiment of the present invention, provided is a vehicle inspection apparatus including: a processor, a memory, a communication interface, and a communication bus, wherein the processor, the memory, and the communication interface communicate with each other via the communication bus;
the memory is used for storing at least one executable instruction that causes the processor to perform the operations according to the vehicle inspection method described above.

For the vehicle inspection method according to an embodiment of the present invention, when a measured item of a to-be-measured vehicle is acquired and a user makes a selection to determine the selected measured item, measurement guidance information about the selected measured item is acquired to prompt the user to connect a vehicle inspection system including an oscilloscope to the measured item according to the measurement guidance information, and then the selected measured item is measured and a signal waveform corresponding to the measured item is displayed. Through the above-mentioned method, the user can connect and measure the oscilloscope and the selected measured item efficiently and accurately according to the measurement guidance information, which greatly reduces the learning cost and the use threshold of the vehicle inspection system including the oscilloscope, improves the vehicle inspection efficiency, simplifies the user operation and improves the user experience.

While the foregoing is directed to embodiments of the present invention, other and further embodiments of the invention may be devised without departing from the basic scope thereof, and the scope thereof is determined by the claims that follow.

### BRIEF DESCRIPTION OF THE DRAWINGS

The drawings are only for purposes of illustrating the embodiments and are not to be construed as limiting the invention. Moreover, like reference numerals designate like parts throughout the several views. In the drawings:
FIG. 1 is a schematic diagram showing a configuration of a vehicle inspection system according to an embodiment of the present invention;
FIG. 2 is a flow diagram showing a vehicle inspection method according to an embodiment of the present invention;
FIG. 3 is an exemplary diagram showing a to-be-measured vehicle interface according to an embodiment of the present invention;
FIG. 4 is an exemplary diagram showing measured item selection and associated measurement guidance information display interface according to an embodiment of the present invention;
FIG. 5 is a schematic diagram showing a connection and position of a to-be-measured component according to an embodiment of the present invention;
FIG. 6 is an exemplary diagram showing a socket according to an embodiment of the present invention;
FIG. 7 is an exemplary diagram showing an oscilloscope measurement interface according to an embodiment of the present invention;
FIG. 8 is a flowchart showing another vehicle inspection method according to an embodiment of the present invention;
FIG. 9 is an exemplary diagram showing a measurement guidance information editing interface for one measured item according to an embodiment of the present invention;
FIG. 10 is a schematic diagram showing a configuration of a vehicle inspection apparatus according to an embodiment of the present invention;
FIG. 11 is schematic diagram showing a configuration of a vehicle inspection apparatus according to an embodiment of the present invention.

### DETAILED DESCRIPTION OF THE INVENTION

Hereinafter, exemplary embodiments of the present invention will be described in more detail with reference to the accompanying drawings. While the drawings show exemplary embodiments of the invention, it should be understood that the invention may be embodied in various forms and should not be construed as limited to the embodiments set forth herein.

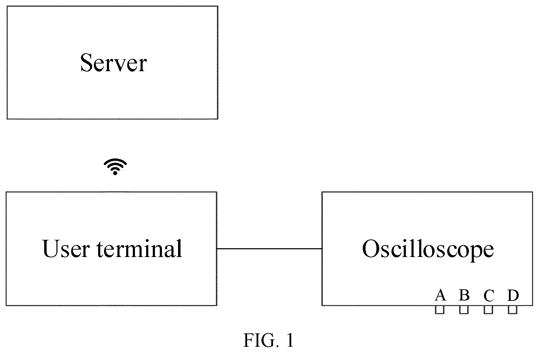

Embodiments of the present invention are primarily applicable to scenarios in which a vehicle is inspected using a vehicle inspection system including an oscilloscope. FIG. 1 shows a schematic configuration diagram of a vehicle inspection system according to an embodiment of the present invention. The vehicle inspection system includes a user terminal and an oscilloscope, wherein the user terminal includes a terminal device such as a mobile phone, a tablet computer or a personal computer. Preferably, an application program of the vehicle inspection platform can be installed in a user terminal for the user to select and call various hardware devices to inspect the to-be-measured component of the vehicle. The oscilloscope may be a vehicle diagnostic instrument or a Vehicle Communication Measure Interface (VCMI) device with an oscilloscope function. Further, the vehicle inspection system may further include a server, which serves as a cloud data sharing processing center, can centrally store a vehicle information database of a vehicle inspection platform, can be used to provide data related to the vehicle inspection platform for a user terminal, and can also store user-defined data related to various vehicle inspections. Specifically, the user terminal can be connected to the oscilloscope and the server via wired or wireless means, respectively. The oscilloscope is connected to the to-be-measured component of the vehicle. For convenience of description, the measured component of the to-be-measured vehicle is simply referred to as a measured item. As an example, the oscilloscope may have four channels A, B, C and D to connect with the measured items for measurement. However, the oscilloscope may adopt other interface modes for connecting with the measured items of the vehicle, which is not limited herein.

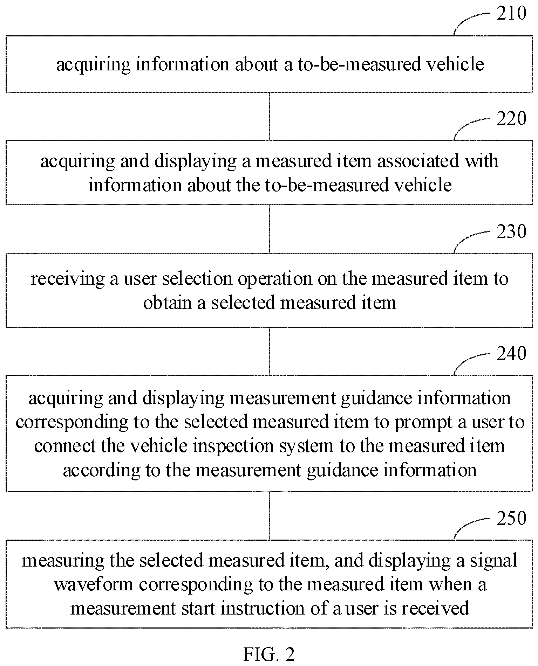

FIG. 2 is a flow chart showing a vehicle inspection method according to an embodiment of the present invention, which is applied to the vehicle inspection system. The method may be performed by the user terminal described above. As shown in FIG. 2, the process includes the steps of:
Step 210: acquiring information about a to-be-measured vehicle.

Specifically, step 210 includes:
step 211: selecting to determine the information about the to-be-measured vehicle through a vehicle inspection platform on a user terminal when a user inspects a to-be-measured vehicle using the vehicle inspection system.

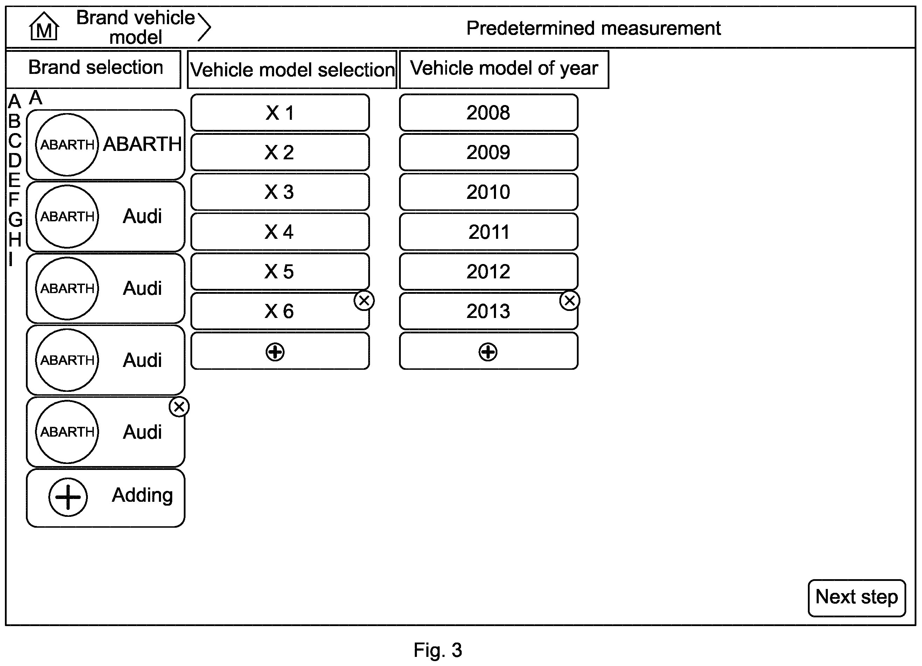

FIG. 3 is an exemplary diagram showing a to-be-measured vehicle interface according to an embodiment of the present invention. The interface may be a specific interface in a vehicle inspection platform. Specifically, the user terminal can obtain the brand, model and year of each vehicle from the local vehicle information database information database and present the information to the user in the interface. Preferably, the vehicle inspection system may include a server, and the user terminal may download the above-mentioned information from the vehicle information database of the server and display same in the to-be-measured vehicle selection interface. Under the circumstance of this interface, the user can select the brand, model and year of the vehicle to determine the accurate the information about the to-be-measured vehicle. Specifically, in the vehicle information database, information about each to-be-measured vehicle may correspond to vehicle information identification (ID).

The user has a corresponding user ID on the vehicle inspection platform; preferably, if the user has stored user-defined information about the to-be-measured vehicle (such as information about the brand, model and annual payment of the to-be-measured vehicle) corresponding to the user ID in the above-mentioned vehicle information database, the user terminal includes the user-defined information about the to-be-measured vehicle corresponding to the user ID in the information about the to-be-measured vehicle displayed to the user when the to-be-measured vehicle is selected.

Step 212: acquiring by the user terminal the information about the to-be-measured vehicle according to the selection of the user.

Specifically, the user terminal acquires the vehicle information ID corresponding to the information about the to-be-measured vehicle by the user selecting the determined the information about the to-be-measured vehicle (including the user-defined information about the to-be-measured vehicle) on the vehicle inspection platform.

Step 220: acquiring and displaying a measured item associated with information about the to-be-measured vehicle.

Specifically, the user terminal acquires all the measured items associated with the vehicle information ID from the vehicle information database through the vehicle information ID corresponding to the information about the to-be-measured vehicle. Also, the database may be a vehicle information database local to the user terminal or a vehicle information database in the server. For simplicity of description, unless otherwise specified, the vehicle information database according to an embodiment of the present invention includes a vehicle information database local to the user terminal and a vehicle information database in the server. In the vehicle information database, each measured item may correspond to one measured item ID.

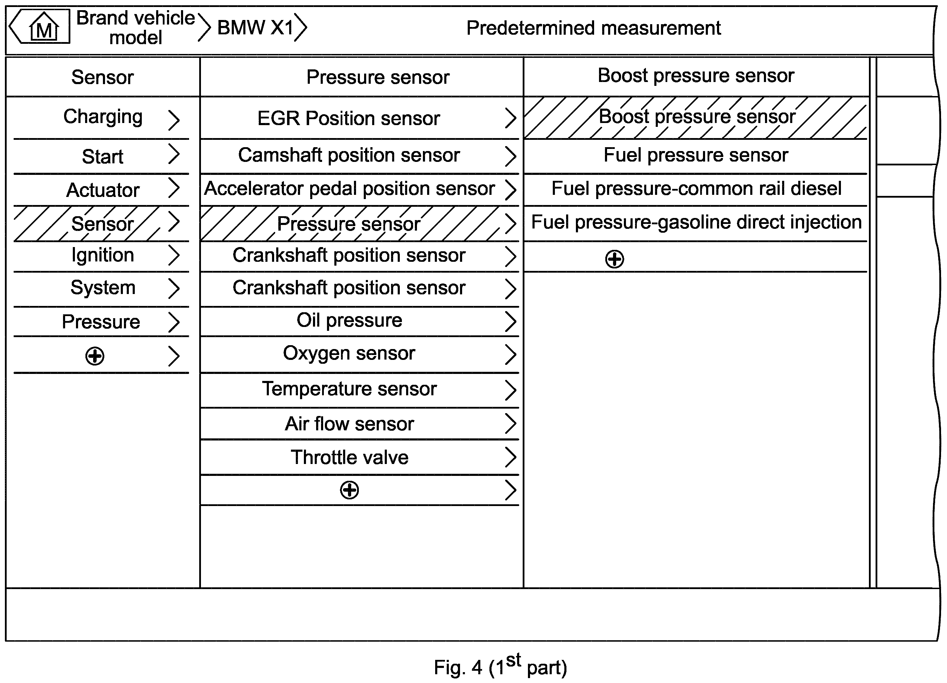

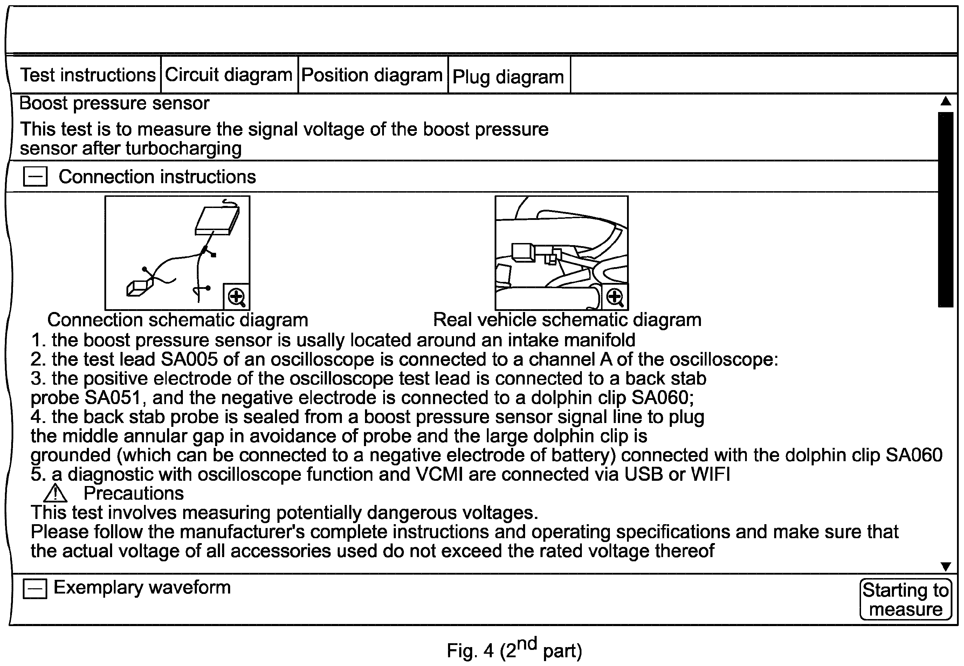

FIG. 4 is an exemplary diagram showing measured item selection and associated measurement guidance information display interface according to an embodiment of the present invention. The interface may be a specific interface in a vehicle inspection platform. Specifically, after acquiring all the measured items associated with information about the to-be-measured vehicle, the user terminal may display the measured item name information in the interface for the user to select.

Preferably, if the user stores a user-defined measured item associated with the vehicle information ID corresponding to the user ID in the vehicle information database, the user terminal includes the user-defined measured item in the measured item displayed to the user when the measured item is selected.

Step 230: receiving a user selection operation on the measured item to obtain a selected measured item.

Specifically, in the above-mentioned measured item selection and related measurement guidance information display interface, the user selects a measured item related to the to-be-measured vehicle, such as the boost pressure sensor in FIG. 4.

After the user selects a measured item (including a user-defined measured item), the user terminal receives the user's selection operation on the measured item to obtain the selected measured item. The selected measured item corresponds to a measured item ID and is associated with the vehicle information ID.

Step 240: acquiring and displaying measurement guidance information corresponding to the selected measured item to prompt a user to connect the vehicle inspection system to the measured item according to the measurement guidance information.

Specifically, step 240 further includes:
Step 241: querying and acquiring, by the user terminal, measurement guidance information corresponding to the measured item from the vehicle information database according to the measured item ID corresponding to the selected measured item and the associated above-mentioned vehicle information ID.

Optionally, the measurement guidance information includes lead connection guidance. The lead connection guide may specifically include a wiring accessory list and wiring step information. The list of wiring accessories is used to indicate to the user what accessories are required to connect the oscilloscope to the measured item, e.g. under the "boost pressure sensor" measured item, the list of wiring accessories can be: oscilloscope test leads SA005, back stab probe SA051 and dolphin clip SA060. The wiring step information is used to instruct the user how to use the wiring accessories to connect the oscilloscope to the measured item. In the circumstance of the "boost pressure sensor" measured item, the wiring step information can be: "1. a boost pressure sensor is located; 2, the test lead SA005 of an oscilloscope is connected to a channel A of the oscilloscope; 3, the positive electrode of the oscilloscope test lead is connected to a back stab probe SA051, and the negative electrode is connected to a dolphin clip SA060; 4, the back stab probe is sealed from a boost pressure sensor signal line to plug the middle annular gap in avoidance of probe and the large dolphin clip is grounded (which can be connected to a negative electrode of battery)".

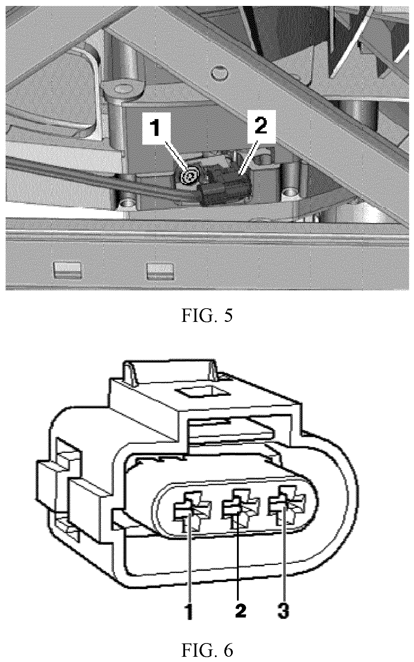

Optionally, the measurement guidance information further includes at least one of the following: a measurement purpose, measurement precautions, a measurement start instruction and a measurement guidance diagram. The measurement purpose (or called the purpose of the inspection) is to explain to the user a goal of the measurement for this measurement, e.g. in a circumstance of the "boost pressure sensor" measurement, the measurement purpose can be: "this test measures the turbocharged signal voltage of the boost pressure sensor". Measurement precautions are used to explain to the user the dangerous items that should be paid special attention during measurement. For example, under the measured item of "supercharging pressure sensor", the measurement precautions may be: "this test involves measuring potentially dangerous voltages. Please follow the vehicle manufacturer's complete instructions and operating specifications and make sure that the actual voltage of all accessories used does not exceed the rated voltage thereof. The measurement start instruction is used to indicate to the user the operation principle of this measured item and some attention details during measurement. For example, under a circumstance of the measured item of "Fuel Level Sensor", the measurement start instruction may include: "the fuel level sensor is powered by a JBE/REM control unit via an intermittent voltage signal. To inspect a control unit, an oscilloscope measurement is performed on a harness side. The left fuel level sensor continues to remain unplugged". The measurement guidance map may include at least one of the following schematic diagrams: a connection diagram, a position diagram of a measured component, a socket diagram and a circuit diagram, etc. FIG. 5 is a schematic diagram showing a connection and position of a to-be-measured component according to an embodiment of the present invention. In FIG. 5, part 1 is a socket for a measured item connected with an oscilloscope, and part 2 is a plug for an oscilloscope lead. FIG. 6 is an exemplary diagram showing a socket according to an embodiment of the present invention. The socket in the figure is a three-hole socket having three pins.

Optionally, the above-mentioned measurement guidance information further includes: test step information. The test step information is used to explain to the user the overall step of measuring the measured item. As for the measured item of "a boost pressure sensor measurement", the test step information can be: "1. please pay special attention to the purpose and precautions of this test; 2. locate the boost pressure sensor, and connect the channel A of the oscilloscope with the sensor; 3. configure the measurement parameters of the oscilloscope, or use the measurement parameters predetermined by the system, and set the boost pressure sensor and oscilloscope according to the measurement start instructions; 4. do not arbitrarily change the sensor and oscilloscope configuration after starting measurement; 5. after the measurement, please compare the waveform of this measurement signal with the reference waveform, and confirm whether the measurement signal is consistent with the signal characteristic information to determine whether the boost pressure sensor signal is normal".

In an alternative embodiment, if there is no measurement guidance information corresponding to the selected measured item in the vehicle information database, the user may edit the measurement guidance information about the selected measured item to generate user-defined measurement guidance information associated with the user ID.

Saving the user-defined measurement guidance information to the vehicle information database according to the identification of the user when the user edits the measurement guidance information about the selected measured item to generate the user-defined measurement guidance information.

Accordingly, said acquiring and displaying measurement guidance information corresponding to the selected measured item includes:
acquiring and displaying user-defined measurement guidance information corresponding to the selected measured item from the vehicle information database according to the user identifier.

Specifically, according to the measured item ID corresponding to the selected measured item, the associated above-mentioned vehicle information ID and user ID, the user terminal queries and acquires user-defined measurement guidance information corresponding to the measured item from the vehicle information database.

It should be noted that if there are both predetermined measurement guidance information about the vehicle inspection platform and user-defined measurement guidance information in the vehicle information database, the user-defined measurement guidance information is or the user is prompted to make a selection.

Step 242: displaying, by a user terminal, measurement guidance information corresponding to the selected measured item to prompt a user to connect the vehicle inspection system including an oscilloscope to the measured item according to the measurement guidance information.

Specifically, after acquiring measurement guidance information corresponding to the selected measured item, the user terminal displays the above-mentioned measurement guidance information in the vehicle inspection platform for the user to connect the vehicle inspection system including the oscilloscope to the measured item according to the lead connection guide in the measurement guidance information.

The measurement guidance information may be displayed in one interface at a time. Since there may be more contents contained in the measurement guidance information, in order to facilitate the user to read and understand various measurement guidance information, it is preferable to adopt a step-by-step display mode of guide type. For example, in the first step, the user terminal displays measurement purposes and measurement precautions to the user, as shown in the right part of the display interface in FIG. 4; in the second step, a lead wire connection guide and a measurement guidance diagram are shown to a user, as shown in the right part of the display interface in FIG. 4; in the third step, test step information, etc. is shown to a user. Through this wizard guidance, the user is prompted to step by step wiring, step by step measurement, which can further simplify the user operation and improve the user experience. The above-mentioned wizard display mode is only an example, and various measurement guidance information can be flexibly combined step by step according to actual situations to be displayed to a user in an interface, which is not limited herein.

Step 250: measuring the selected measured item, and displaying a signal waveform corresponding to the measured item when a measurement start instruction of a user is received.

Specifically, the use of oscilloscope requires setting many measurement parameters, such as probe, amplitude and so on, and the user needs to configure various measurement parameters of oscilloscope before measurement. Since there are many electrical and sensor components on the to-be-measured vehicle, different parameters should be set for the measurement of each component, which further increases the difficulty and threshold of the oscilloscope. In order to simplify the user operation, it is preferable that the step may include:
when a measurement start instruction from a user is received, acquiring parameter configuration data of the selected measured item, calling the oscilloscope to load the parameter configuration data to measure the measured item, acquiring a measurement signal of the measured item and outputting a signal waveform corresponding to the measurement signal, and displaying the signal waveform output by the oscilloscope.

Specifically, when receiving a predetermined measurement start instruction of a user, the user terminal acquires parameter configuration data corresponding to the measured item from the above-mentioned vehicle information database according to the measured item ID corresponding to the selected measured item and the associated above-mentioned vehicle information ID. The parameter configuration data can be a predetermined oscilloscope measurement parameter configuration file of the vehicle inspection platform.

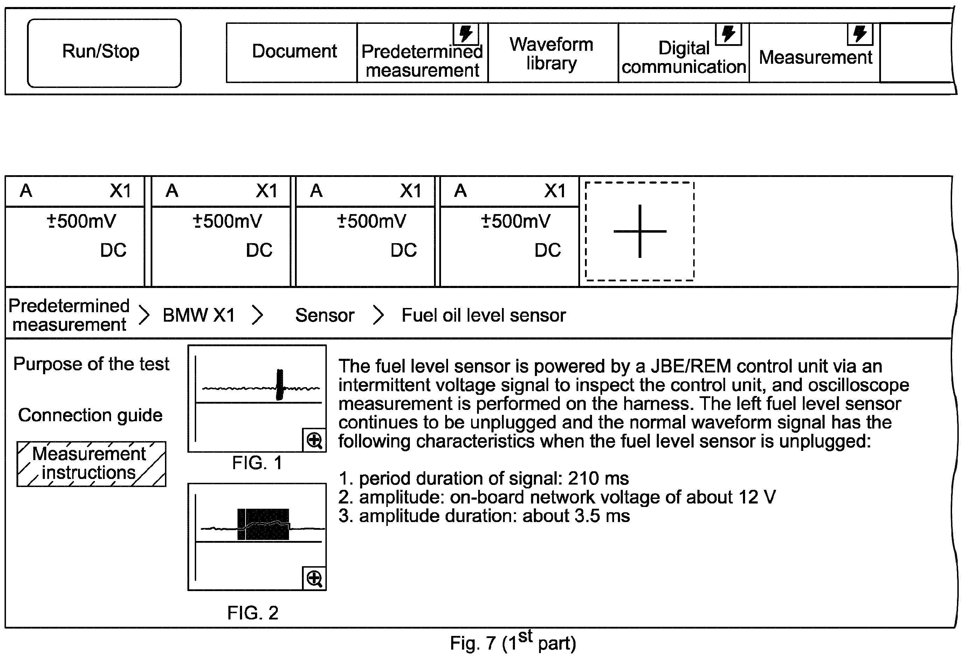

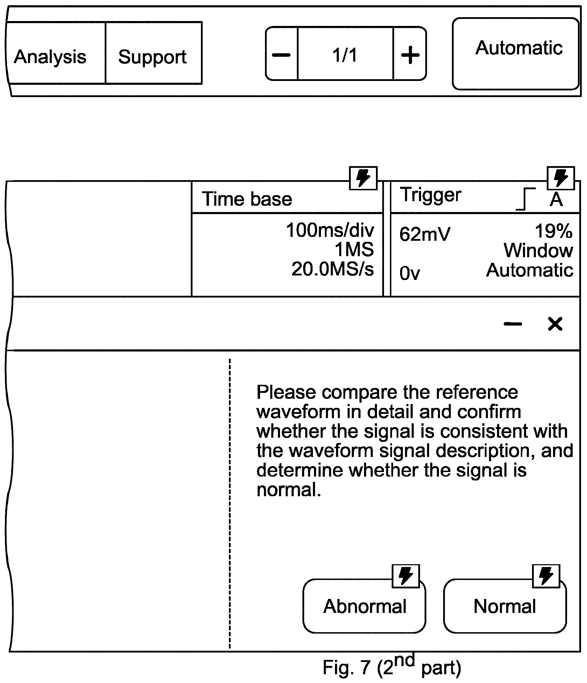

A user terminal transmits the parameter configuration data to an oscilloscope, calls the oscilloscope to load the parameter configuration data to measure a measured item, the oscilloscope acquires a measurement signal of the measured item and outputs a signal waveform corresponding to the measurement signal, and after receiving the signal waveform transmitted by the oscilloscope, the user terminal displays the signal waveform. FIG. 7 is an exemplary diagram showing an oscilloscope measurement interface according to an embodiment of the present invention. The signal waveform output from the oscilloscope measurement is shown to the user.

By using the predetermined parameter configuration data, the user can load a key to quickly start measurement, which can further reduce the difficulty and threshold of using the vehicle inspection system including an oscilloscope, simplify the user operation, improve the vehicle inspection efficiency and enhance the user experience.

In order to facilitate the user to determine whether the signal waveform is normal, predetermined measurement result information corresponding to the above-mentioned parameter configuration data can be acquired and displayed to the user. Preferably, displaying a signal waveform corresponding to the measured item may include:
step 260: acquiring predetermined measurement result information corresponding to the parameter configuration data; displaying the predetermined measurement result information so that a user compares the signal waveform with the predetermined measurement result information to determine a measurement result.

Specifically, the user terminal may acquire predetermined measurement result information corresponding to the parameter configuration data when acquiring the parameter configuration data from the above-mentioned vehicle information database. The predetermined measurement result information includes a reference waveform, and the reference waveform is a normal signal waveform generated after the oscilloscope loads the parameter configuration data to measure the measured item. Further, the predetermined measurement result information may also include predetermined measurement signal characteristic information, wherein the measurement signal characteristic information is used for describing signal characteristic data values, such as period and amplitude, of the measured item signal.

After acquiring the above-mentioned predetermined measurement result information, the user terminal displays the information to the user. If the user terminal has previously acquired the measurement specification, the measurement specification information may also be presented to assist the user in measuring. As shown in FIG. 7, for the measured item of "a fuel level sensor", the reference waveform is shown on the lower right side, and the above-mentioned measurement start instruction and measurement signal characteristic information are shown in the lower middle, wherein the predetermined measurement signal characteristic information may be: "1. the cycle duration of the signal is: 210 ms, 2, amplitude: on-board network voltage 12 V, 3, amplitude duration: about 3.5 ms".

A user terminal displays the above-mentioned predetermined measurement result information to a user so that the user compares the signal waveform with the predetermined measurement result information to determine a measurement result. If the user can compare the signal waveform output by this measuring oscilloscope with the reference waveform, whether the signal waveform is normal is determined. If the predetermined measurement result information also includes predetermined measurement signal feature information, a user can compare the signal feature information measured this time with the predetermined measurement signal feature information to determine whether they are consistent. If the signal waveform is normal (optionally, the measurement signal characteristic information is consistent), it can be determined that the measured item operates normally, otherwise, the measured item operates abnormally.

When the measured item operates abnormally, the user terminal may display various measurement guidance information acquired before to prompt the user to further verify whether the measurement operation is correct. For example, whether the lead wire connection is correct, whether the measurement steps meet the requirements, etc.

Alternatively, the user terminal may transmit the measured signal waveform to a server in the vehicle inspection system to assist in determining the performance of the measurement. Therefore, after displaying the signal waveform corresponding to the measured item, including:
Step 270: transmitting the signal waveform to the server, so that the server compares the signal waveform with predetermined measurement result information, and determines a measurement result; wherein the predetermined measurement result information is predetermined measurement result information corresponding to the parameter configuration data; receiving the measurement result transmitted by the server.

Specifically, the user terminal transmits a measured item ID corresponding to the selected measured item, the associated above-mentioned vehicle information ID and a signal waveform of this measurement to the server; after receiving, the server queries and acquires predetermined measurement result information corresponding to the parameter configuration data used by the user terminal in this measurement from the vehicle information database stored in the server via the measured item ID and the vehicle information ID. The predetermined measurement result information includes the same contents as in step 260.

The server compares the signal waveform with a reference waveform in predetermined measurement result information, and determines whether the signal waveform is normal. If the predetermined measurement result information further includes predetermined measurement signal feature information, the server compares the signal feature information measured this time with the predetermined measurement signal feature information, and determines whether they are consistent. If the signal waveform is normal (optionally, the measurement signal characteristic information is consistent), it can be determined that the measured item operates normally, otherwise, the measured item operates abnormally. The server transmits the measured item ID and the measurement result to the user terminal.

After receiving the measured item ID and the measurement result transmitted by the server, the user terminal displays the measurement result that the measured item operates normally or abnormally to the user.

When the measured item operates abnormally, the user terminal may display various measurement guidance information acquired before to prompt the user to further verify whether the measurement operation is correct. For example, whether the lead wire connection is correct, whether the measurement steps meet the requirements, etc.

Alternatively, the user terminal may itself assist in determining the behavior of the measurement. Thus, after displaying the signal waveform corresponding to the measured item, including:
Step 280: acquiring predetermined measurement result information corresponding to the parameter configuration data; comparing the signal waveform with the predetermined measurement result information to determine a measurement result.

Specifically, the user terminal may acquire predetermined measurement result information corresponding to the parameter configuration data when acquiring the parameter configuration data from the above-mentioned vehicle information database. The predetermined measurement result information includes the same contents as in step 260.

After acquiring the above-mentioned predetermined measurement result information, the user terminal compares the signal waveform with a reference waveform in the predetermined measurement result information, and determines whether the signal waveform is normal. If the predetermined measurement result information also includes predetermined measurement signal feature information, a user terminal compares the signal feature information measured this time with the predetermined measurement signal feature information to determine whether they are consistent. If the signal waveform is normal (optionally, the measurement signal characteristic information is consistent), it can be determined that the measured item operates normally, otherwise, the measured item operates abnormally.

When the measured item operates abnormally, the user terminal may display various measurement guidance information acquired before to prompt the user to further verify whether the measurement operation is correct. For example, whether the lead wire connection is correct, whether the measurement steps meet the requirements, etc.

In an alternative embodiment, if there is no parameter configuration data and corresponding predetermined measurement result information corresponding to the selected measured item in the vehicle information database, a user can edit the parameter configuration data of the selected measured item to generate user-defined parameter configuration data associated with the user ID, and call an oscilloscope to load the user-defined parameter configuration data to measure the selected measured item to generate user-defined predetermined measurement result information associated with the user ID.

When a user edits parameter configuration data of the selected measured item to generate user-defined parameter configuration data, and calls an oscilloscope to load the user-defined parameter configuration data to measure the selected measured item to generate user-defined predetermined measurement result information, a user terminal saves the user-defined parameter configuration data and user-defined predetermined measurement result information to the above-mentioned vehicle information database according to the identification of the user;

Accordingly, said acquiring parameter configuration data of the selected measured item includes::
acquiring user-defined parameter configuration data of the selected measured item from the vehicle information database according to the identifier of a user;
the predetermined measurement result information includes the user-defined predetermined measurement result information corresponding to the identification of the user.

Specifically, the user terminal queries and acquires user-defined parameter configuration data corresponding to the selected measured item from the vehicle information database according to the measured item ID corresponding to the selected measured item, the associated above-mentioned vehicle information ID and the user ID. Further, user-defined predetermined measurement result information corresponding to the user-defined parameter configuration data can be acquired.

It needs to be stated that if there are both predetermined parameter configuration data and predetermined measurement result information about the vehicle inspection platform and predetermined parameter configuration data and predetermined measurement result information about the user-defined parameter configuration data and predetermined measurement result information in the vehicle information database, the user-defined parameter configuration data and predetermined measurement result information are preferentially acquired to be used, or the user is prompted to make a selection.

In summary, the embodiments of the present invention provide a vehicle inspection method, when a measured item of a to-be-measured vehicle is acquired and a user makes a selection to determine the selected measured item, measurement guidance information about the selected measured item is acquired to prompt the user to connect a vehicle inspection system including an oscilloscope to the measured item according to the measurement guidance information, and then the selected measured item is measured and a signal waveform corresponding to the measured item is displayed. Through the above-mentioned method, the user can connect and measure the oscilloscope and the selected measured item efficiently and accurately according to the measurement guidance information, which greatly reduces the learning cost and the use threshold of the vehicle inspection system including the oscilloscope, improves the vehicle inspection efficiency, simplifies the user operation and improves the user experience. In addition, when information about the to-be-measured vehicle, measured items, measurement guidance information, parameter configuration data and predetermined measurement result information are acquired from the above-mentioned vehicle information database, various user-defined information data previously saved by a user can be acquired according to a user identifier, which is equivalent to providing a personalized vehicle information database for the user, improving the flexibility of the above-mentioned vehicle inspection method, improving the convenience and working efficiency of user inspection and maintenance, facilitating quick maintenance for the user, and further improving the user service experience.

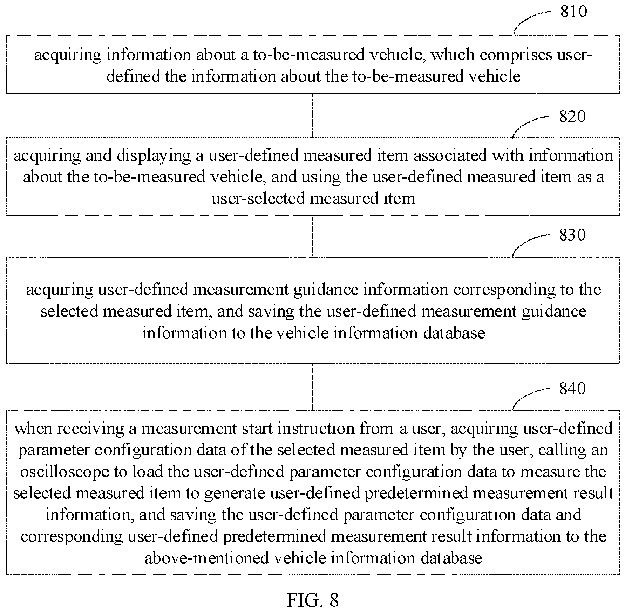

Since there are numerous vehicle models updated rapidly, the above-mentioned vehicle information database cannot include all vehicle models and measured items; in addition, some experienced users wish to add personalized measurement guidance, oscilloscope measurement parameters, reference waveforms and other information, in the vehicle inspection method according to an embodiment of the present invention, a user can add the information about the to-be-measured vehicle, measured items, measurement guidance information, parameter configuration data and/or predetermined measurement result information, and store same in the above-mentioned vehicle information database and correspond to a user identifier so as to be quickly used in the next vehicle inspection. FIG. 8 is a flowchart showing another vehicle inspection method according to an embodiment of the present invention, in which a user-defined step is added to the vehicle inspection method shown in FIG. 2. The details are as follows:
step 801: acquiring information about a to-be-measured vehicle, which includes user-defined the information about the to-be-measured vehicle.

Specifically, selecting to determine the information about the to-be-measured vehicle through a vehicle inspection platform on a user terminal when a user inspects a to-be-measured vehicle using the vehicle inspection system. If there is no information corresponding to the to-be-measured vehicle in the vehicle information database of the vehicle inspection platform, the user adds user-defined information about the to-be-measured vehicle (including information such as the brand, model and yearly payment of the to-be-measured vehicle) and saves same to the vehicle information database mentioned above. The user-defined information about the to-be-measured vehicle also has a vehicle information ID and is associated with the user ID of the user. As an example, the user may add user-defined information about the to-be-measured vehicle by clicking a "+" symbol in a to-be-measured vehicle interface shown in FIG. 3. Thus, the next time the information about the to-be-measured vehicle is presented to the user, the user-defined information about the to-be-measured vehicle corresponding to the user ID is included.

The user terminal acquires the information about the to-be-measured vehicle defined by the user according to the operation added by the user.

Step 820: acquiring and displaying a user-defined measured item associated with information about the to-be-measured vehicle, and using the user-defined measured item as a user-selected measured item.

Specifically, if there is no measured item required by the user in the vehicle information database, the user may add a user-defined measured item associated with information about the to-be-measured vehicle and save same to the vehicle information database. Specifically, in the vehicle information database, the user-defined measured item has a measured item ID corresponding to a user identifier of the user and associated with the vehicle information ID of the information about the to-be-measured vehicle. As an example, the user may add a user-defined measured item by clicking a "+" symbol in the measured item selection and related measurement guidance information display interface shown in FIG. 4. Thus, the next time the measured item associated with information about the to-be-measured vehicle is presented to the user, the user-defined information about the to-be-measured vehicle corresponding to the user ID is included.

A user terminal acquires and displays a user-defined measured item according to an addition operation of a user, and uses the user-defined measured item as a measured item selected by the user.

Step 830: acquiring user-defined measurement guidance information corresponding to the selected measured item, and saving the user-defined measurement guidance information to the vehicle information database.

Specifically, the contents of the measurement guidance information are consistent with the vehicle inspection method embodiment described above, and will not be described in detail herein.

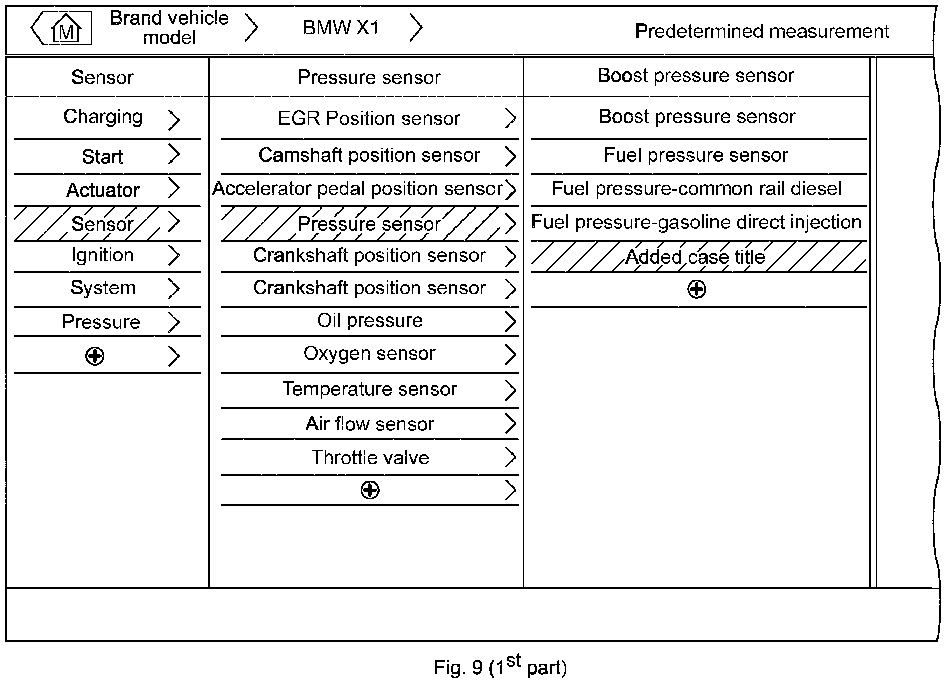

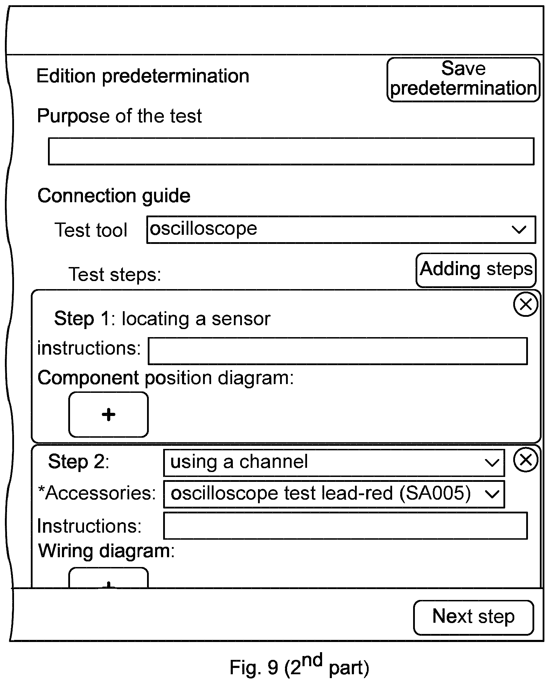

If there is no measurement guidance information corresponding to the selected measured item in the vehicle information database, the user can edit the measurement guidance information adding the selected measured item in the vehicle inspection platform via the user terminal, generate user-defined measurement guidance information associated with the user ID, and save same to the above-mentioned vehicle information database. Specifically, in the vehicle information database, the user-defined measurement guidance information corresponds to a user identifier of the user, and a measured item ID corresponding to the selected measured item is associated with the associated vehicle information ID. FIG. 9 is an exemplary diagram showing a measurement guidance information editing interface for one measured item according to an embodiment of the present invention. As an example, the user can add user-defined measurement guidance information corresponding to the measured item, such as test purpose, lead connection guide and test step information, etc. by clicking a "+" symbol in the editing interface shown in FIG. 9.

In this way, the next time the user terminal acquires and displays the measurement guidance information corresponding to the selected measured item, the user-defined measurement guidance information corresponding to the user ID is included.

Step 840: when receiving a measurement start instruction from a user, acquiring user-defined parameter configuration data of the selected measured item by the user, calling an oscilloscope to load the user-defined parameter configuration data to measure the selected measured item to generate user-defined predetermined measurement result information, and saving the user-defined parameter configuration data and corresponding user-defined predetermined measurement result information to the above-mentioned vehicle information database.

Specifically, the contents of the parameter configuration data and the predetermined measurement result information are consistent with the embodiment of the vehicle inspection method described above and will not be described in detail herein.

If there is no parameter configuration data and corresponding predetermined measurement result information corresponding to the selected measured item in the vehicle information database, a user can edit the parameter configuration data of the selected measured item via a user terminal to generate user-defined parameter configuration data associated with the user ID, and call an oscilloscope to load the user-defined parameter configuration data to measure the measured item to generate user-defined predetermined measurement result information associated with the user ID, and save the user-defined parameter configuration data and user-defined predetermined measurement result information to the above-mentioned vehicle information database. Specifically, in the vehicle information database, the user-defined parameter configuration data and the user-defined predetermined measurement result information correspond to a user identifier of the user, and a measured item ID corresponding to the selected measured item is associated with the associated above-mentioned vehicle information ID.

In this way, when the user terminal acquires the parameter configuration data of the selected measured item and the corresponding predetermined measurement result information the next time, the user terminal includes the user-defined parameter configuration data and the user-defined predetermined measurement result information corresponding to the user ID.

It is to be noted that the vehicle inspection method according to the embodiment of the present invention is based on the same concept as the vehicle inspection method shown in FIG. 2, and the description of the embodiment of the vehicle inspection method described above may be referred to, and will not be repeated here.

In summary, according to the vehicle inspection method provided in the embodiments of the present invention, a user can add the information about the to-be-measured vehicle, measured items, measurement guidance information, parameter configuration data and/or predetermined measurement result information via a user terminal, and store same in the above-mentioned vehicle information database to be corresponding to a user identifier, which is equivalent to providing a personalized vehicle information database for the user, so that various measurement-related information defined by the user can be quickly called and used during the next vehicle inspection. Through the above-mentioned methods, the flexibility of vehicle inspection is improved, the convenience and working efficiency of user inspection and maintenance are improved, which is convenient for the user to have quick maintenance, and the user's business experience is further improved.

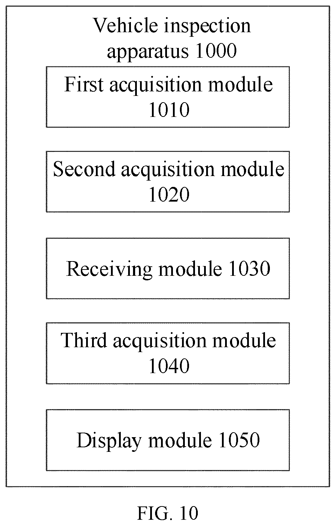

FIG. 10 is a schematic diagram showing a configuration of a vehicle inspection apparatus according to an embodiment of the present invention. The vehicle inspection apparatus may specifically correspond to a user terminal in the vehicle inspection system described above. The vehicle inspection system includes an oscilloscope. As shown in FIG. 10, the apparatus 1000 includes:
a first acquisition module 1010 for acquiring information about a to-be-measured vehicle;
a second acquisition module 1020 for acquiring and displaying a measured item associated with information about the to-be-measured vehicle;
a receiving module 1030 for receiving a user selection operation on the measured item to obtain a selected measured item;
a third acquisition module 1040 for acquiring and displaying measurement guidance information corresponding to the selected measured item to prompt a user to connect the vehicle inspection system to the measured item according to the measurement guidance information; and
a display module 1050 for measuring the selected measured item and displaying a signal waveform corresponding to the measured item when receiving a measurement start instruction from a user.

In an alternative, the measurement guidance information includes lead connection guidance.

Optionally, the measurement guidance information further includes at least one of: a measurement purpose, measurement precautions, a measurement start instruction and a measurement guidance diagram.

In an alternative, the display module 1050 includes:
a fourth acquisition unit 1051 for acquiring parameter configuration data of the selected measured item when a measurement start instruction of a user is received;
an calling unit 1052 for calling the oscilloscope to load the parameter configuration data to measure the measured item, acquiring a measurement signal of the measured item and outputting a signal waveform corresponding to the measurement signal;
a display unit 1053 for displaying a signal waveform output by the oscilloscope.

In an alternative, the above apparatus 1000 further includes:
a fifth acquisition module 1060 for acquiring predetermined measurement result information corresponding to the parameter configuration data; displaying the predetermined measurement result information so that a user compares the signal waveform with the predetermined measurement result information to determine a measurement result.

In an alternative, the vehicle inspection system includes a server; the apparatus 1000 further includes:
a transmitting module 1070 for transmitting the signal waveform to the server, so that the server compares the signal waveform with predetermined measurement result information, and determines a measurement result; wherein the predetermined measurement result information is predetermined measurement result information corresponding to the parameter configuration data; and

A second receiving module 1080 for receiving the measurement result transmitted by the server.

In an alternative, the above apparatus 1000 further includes:
a determination module 1090 for acquiring predetermined measurement result information corresponding to the parameter configuration data; comparing the signal waveform with the predetermined measurement result information to determine a measurement result.

In an alternative, the above apparatus 1000 further includes:

A first saving module 1100 for saving user-defined measurement guidance information to a vehicle information database according to a user identifier when the user edits measurement guidance information about the selected measured item to generate the user-defined measurement guidance information.

Accordingly, the third acquisition module 1040 includes:
a third acquisition unit 1041 for acquiring and displaying user-defined measurement guidance information corresponding to the selected measured item from the vehicle information database according to the user identifier.

In an alternative, the above apparatus 1000 further includes:
a second saving module 1110 used for saving the user-defined parameter configuration data and user-defined predetermined measurement result information to a vehicle information database according to an identifier of the user when a user edits parameter configuration data of the selected measured item to generate user-defined parameter configuration data, and calls an oscilloscope to load the user-defined parameter configuration data to measure the selected measured item to generate user-defined predetermined measurement result information;
accordingly, the fourth acquisition unit 1051 includes:
a fourth acquisition subunit 10511 for acquiring user-defined parameter configuration data of the selected measured item from the vehicle information database according to the user identifier;
the predetermined measurement result information includes the user-defined predetermined measurement result information corresponding to the identification of the user.

It is to be noted that the vehicle inspection apparatus described above is based on the same concept as the vehicle inspection method according to the embodiment of the present invention, and the detailed description thereof may be referred to in the description of the embodiment of the vehicle inspection method described above and will not be repeated here.

According to the vehicle inspection apparatus provided by an embodiment of the present invention, and when a measured item of a to-be-measured vehicle is acquired and a user makes a selection to determine the selected measured item, measurement guidance information about the selected measured item is acquired to prompt the user to connect a vehicle inspection system including an oscilloscope to the measured item according to the measurement guidance information, and then the selected measured item is measured and a signal waveform corresponding to the measured item is displayed. Through the apparatus, the user can connect and measure the oscilloscope and the selected measured item efficiently and accurately according to the measurement guidance information, which greatly reduces the learning cost and the use threshold of the vehicle inspection system including the oscilloscope, improves the vehicle inspection efficiency, simplifies the user operation and improves the user experience. In addition, when measurement guidance information, parameter configuration data and predetermined measurement result information are acquired from the above-mentioned vehicle information database, various user-defined information data previously saved by a user can be acquired according to a user identifier, which is equivalent to providing a personalized vehicle information database for the user, improving the flexibility of the above-mentioned vehicle inspection method, improving the convenience and working efficiency of user inspection and maintenance, facilitating quick maintenance for the user, and further improving the user service experience.

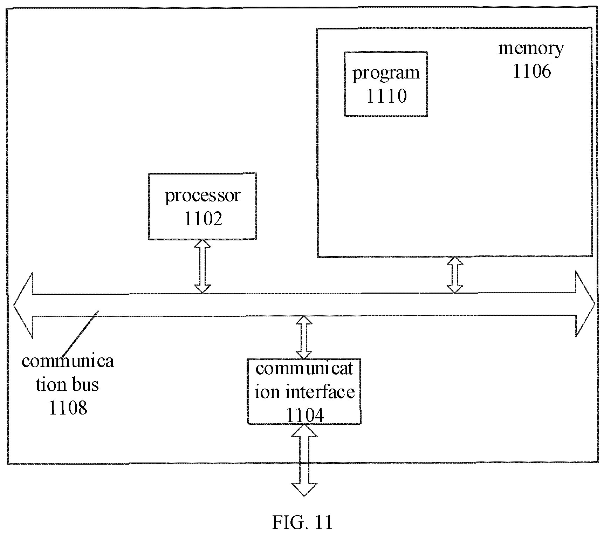

FIG. 11 is a schematic diagram showing a configuration of an inspection apparatus according to an embodiment of the present invention, and a specific embodiment of the present invention is not limited to a specific implementation of the inspection apparatus.

As shown in FIG. 11, the vehicle inspection apparatus may include: a processor 1102, a Communications Interface 1104, a memory 1106, and a communication bus 1108.

Wherein: the processor 1102, the communication interface 1104, and the memory 1106 communicate with each other over a communication bus 1108. A communication interface 1104 for communicating with network elements of other devices such as a network element of a client or other servers, etc. A processor 1102 for executing a program 1110 may specifically perform the relevant steps described above for use in the vehicle inspection method embodiment.

In particular, program 1110 may include program code including computer-executable instructions.

Processor 1102 may be a central processing unit CPU, or an Application Specific Integrated Circuit (ASIC), or one or more integrated circuits configured to implement embodiments of the present invention. The vehicle inspection device includes one or more processors, which may be of the same type, such as one or more CPUs; it may also be a different type of processor, such as one or more CPUs and one or more ASICs.

The memory 1106 is used for storing a program 1110. The memory 1106 may include high-speed RAM memory, and may also include non-volatile memory, such as at least one disk memory.

The program 1110 may be specifically called by the processor 1102 to cause the vehicle inspection apparatus to perform the following operations:
acquiring information about a to-be-measured vehicle;
acquiring and displaying a measured item associated with information about the to-be-measured vehicle;
receiving a user selection operation on the measured item to obtain a selected measured item;
acquiring and displaying measurement guidance information corresponding to the selected measured item to prompt a user to connect the vehicle inspection system to the measured item according to the measurement guidance information; and
measuring the selected measured item, and displaying a signal waveform corresponding to the measured item when a measurement start instruction of a user is received.

In an alternative, the measurement guidance information includes lead connection guidance.

In an alternative, the measurement guidance information further includes at least one of: measurement purpose, measurement precautions, measurement instruction and measurement guidance diagram.

In an alternative, said measuring the selected measured item, and displaying a signal waveform corresponding to the measured item when a measurement start instruction of a user is received includes:
when a measurement start instruction from a user is received, acquiring parameter configuration data of the selected measured item, calling the oscilloscope to load the parameter configuration data to measure the measured item, acquiring a measurement signal of the measured item and outputting a signal waveform corresponding to the measurement signal, and displaying the signal waveform output by the oscilloscope.

In an alternative, after said displaying a signal waveform corresponding to the measured item, including:
acquiring predetermined measurement result information corresponding to the parameter configuration data; displaying the predetermined measurement result information so that a user compares the signal waveform with the predetermined measurement result information to determine a measurement result.

In an alternative, the vehicle inspection system includes a server; after said displaying a signal waveform corresponding to the measured item, including:
transmitting the signal waveform to the server, so that the server compares the signal waveform with predetermined measurement result information, and determines a measurement result; wherein the predetermined measurement result information is predetermined measurement result information corresponding to the parameter configuration data; and
receiving the measurement result transmitted by the server.

In an alternative, after said displaying a signal waveform corresponding to the measured item, including:
acquiring predetermined measurement result information corresponding to the parameter configuration data; comparing the signal waveform with the predetermined measurement result information to determine a measurement result.

In an alternative, the acquiring information about a to-be-measured vehicle includes:
saving user-defined measurement guidance information to a vehicle information database according to a user identifier when the user edits measurement guidance information about the selected measured item to generate the user-defined measurement guidance information;
said acquiring and displaying measurement guidance information corresponding to the selected measured item includes:
acquiring and displaying user-defined measurement guidance information corresponding to the selected measured item from the vehicle information database according to the user identifier.

In an alternative, the acquiring information about a to-be-measured vehicle includes:
saving the user-defined parameter configuration data and user-defined predetermined measurement result information to a vehicle information database according to a user identifier when the user edits parameter configuration data of the selected measured item to generate user-defined parameter configuration data, and calls an oscilloscope to load the user-defined parameter configuration data to measure the selected measured item to generate user-defined predetermined measurement result information;
said acquiring parameter configuration data of the selected measured item includes:
acquiring user-defined parameter configuration data of the selected measured item from the vehicle information database according to the user identifier;
the predetermined measurement result information includes the user-defined predetermined measurement result information corresponding to the identification of the user.

The vehicle inspection apparatus described above can perform the operation of the vehicle inspection device in the vehicle inspection method according to an embodiment of the present invention, and has corresponding functional modules and advantageous effects. Technical details that are not described in detail in this embodiment can be referred to the vehicle inspection method embodiment described above.

According to the vehicle inspection apparatus provided by an embodiment of the present invention, and when a measured item of a to-be-measured vehicle is acquired and a user makes a selection to determine the selected measured item, measurement guidance information about the selected measured item is acquired to prompt the user to connect a vehicle inspection system including an oscilloscope to the measured item according to the measurement guidance information, and then the selected measured item is measured and a signal waveform corresponding to the measured item is displayed. Through the device, the user can connect and measure the oscilloscope and the selected measured item efficiently and accurately according to the measurement guidance information, which greatly reduces the learning cost and the use threshold of the vehicle inspection system including the oscilloscope, improves the vehicle inspection efficiency, simplifies the user operation and improves the user experience. In addition, when measurement guidance information, parameter configuration data and predetermined measurement result information are acquired from the above-mentioned vehicle information database, various user-defined information data previously saved by a user can be acquired according to a user identifier, which is equivalent to providing a personalized vehicle information database for the user, improving the flexibility of the above-mentioned vehicle inspection method, improving the convenience and working efficiency of user inspection and maintenance, facilitating quick maintenance for the user, and further improving the user service experience.

Embodiments of the present invention provide a computer-readable storage medium storing at least one executable instruction which, when executed on a vehicle inspection apparatus, causes the vehicle inspection apparatus to perform the vehicle inspection method in any of the method embodiments described above. Technical details that are not described in detail in the present embodiment may be referred to as a vehicle inspection method embodiment provided by the present invention.

The algorithms or displays presented herein are not inherently related to any particular computer, virtual system, or other apparatus. Various general purpose systems may also be used with the teachings based herein. The structure required to construct such a system is apparent from the above description. Further, embodiments of the present invention are not directed to any particular programming language. It will be appreciated that a variety of programming languages may be used to implement the teachings of the invention as described herein, and that the above description of specific languages is provided to disclose the best mode of carrying out the invention.

In the description provided herein, numerous specific details are set forth. However, it is understood that embodiments of the present invention may be practiced without these specific details. In some instances, well-known methods, structures and techniques have not been shown in detail in order not to obscure the understanding of this description.

Similarly, it should be appreciated that in the above description of example embodiments of the invention, various features of the embodiments of the invention are sometimes grouped together in a single embodiment, figure, or description thereof for the purpose of streamlining the invention and aiding in the understanding of one or more of the various inventive aspects. However, the disclosed methods are not to be interpreted as reflecting an intention that the claimed invention requires more features than are expressly recited in each claim.

It will be appreciated by a person skilled in the art that the modules in the devices in the embodiments may be adapted and arranged in one or more devices different from the embodiment. Modules or units or components in an embodiment may be combined into one module or unit or component and may be divided into a plurality of sub-modules or sub-units or sub-components. All of the features disclosed in this description (including any accompanying claims, abstract and drawings), and all of the processes or elements of any method or apparatus so disclosed, may be combined in any combination, except combinations where at least some of such features and/or processes or elements are mutually exclusive. Each feature disclosed in this description (including any accompanying claims, abstract and drawings) may be replaced by alternative features serving the same, equivalent or similar purpose, unless expressly stated otherwise.

It should be noted that the above-mentioned embodiments illustrate rather than limit the application, and that a person skilled in the art will be able to design alternative embodiments without departing from the scope of the appended claims. In the claims, any reference signs placed between parentheses shall not be construed as limiting the claim. The word "including" does not exclude the presence of elements or steps other than those listed in a claim. The word "a" or "an" preceding an element does not exclude the presence of a plurality of such elements. The invention can be implemented by means of hardware including several distinct elements, and by means of a suitably programmed computer. In the unit claims enumerating several means, several of these means can be embodied by one and the same item of hardware. The use of the words first, second, third, etc. does not denote any order. These words may be interpreted as names. The steps in the above embodiments are not to be construed as limiting the order of execution unless otherwise specified.

## Claims

1. A vehicle inspection method, **characterized in that** the method is applied to a vehicle inspection system comprising an oscilloscope; the method comprises:
acquiring information about a to-be-measured vehicle;
acquiring and displaying a measured item associated with information about the to-be-measured vehicle;
receiving a user selection operation on the measured item to obtain a selected measured item;
acquiring and displaying measurement guidance information corresponding to the selected measured item to prompt a user to connect the vehicle inspection system to the measured item according to the measurement guidance information; and
measuring the selected measured item, and displaying a signal waveform corresponding to the measured item when a measurement start instruction of a user is received.

2. The method according to claim 1, **characterized in that** the measurement guidance information comprises lead connection guidance.

3. The method according to claim 2, **characterized in that** the measurement guidance information further comprises at least one of: a measurement purpose, measurement precautions, a measurement start instruction and a measurement guidance diagram.

4. The method according to claim 1, **characterized in that** said measuring the selected measured item, and displaying a signal waveform corresponding to the measured item when a measurement start instruction of a user is received comprises:
when a measurement start instruction from a user is received, acquiring parameter configuration data of the selected measured item, calling the oscilloscope to load the parameter configuration data to measure the measured item, acquiring a measurement signal of the measured item and
outputting a signal waveform corresponding to the measurement signal, and displaying the signal waveform output by the oscilloscope.

5. The method according to claim 4, **characterized in that** after said displaying the signal waveform corresponding to the measured item, comprising:
acquiring predetermined measurement result information corresponding to the parameter configuration data; displaying the predetermined measurement result information so that a user compares the signal waveform with the predetermined measurement result information to determine a measurement result.

6. The method according to claim 4, **characterized in that** the vehicle inspection system comprises a server; after said displaying a signal waveform corresponding to the measured item, comprising:
transmitting the signal waveform to the server, so that the server compares the signal waveform with predetermined measurement result information, and determines a measurement result; wherein the predetermined measurement result information is predetermined measurement result information corresponding to the parameter configuration data; and
receiving the measurement result transmitted by the server.

7. The method according to claim 4, **characterized in that** after said displaying the signal waveform corresponding to the measured item, comprising:
acquiring predetermined measurement result information corresponding to the parameter configuration data; comparing the signal waveform with the predetermined measurement result information to determine a measurement result.

8. The method according to any one of claims 1 to 3, **characterized in that** the method comprises:
saving user-defined measurement guidance information to a vehicle information database according to a user identifier when the user edits measurement guidance information about the selected measured item to generate the user-defined measurement guidance information;
said acquiring and displaying measurement guidance information corresponding to the selected measured item comprises:
acquiring and displaying user-defined measurement guidance information corresponding to the selected measured item from the vehicle information database according to the user identifier.

9. The method according to any one of claims 5 to 7, **characterized in that** the method comprises:
saving the user-defined parameter configuration data and user-defined predetermined measurement result information to a vehicle information database according to a user identifier when the user edits parameter configuration data of the selected measured item to generate user-defined parameter configuration data, and calls an oscilloscope to load the user-defined parameter configuration data to measure the selected measured item to generate user-defined predetermined measurement result information;
said acquiring parameter configuration data of the selected measured item comprises:
acquiring user-defined parameter configuration data of the selected measured item from the vehicle information database according to the user identifier;
the predetermined measurement result information comprises the user-defined predetermined measurement result information corresponding to the identification of the user.

10. A vehicle inspection apparatus, **characterized in that** the apparatus is applied to an inspection system comprising an oscilloscope; the apparatus comprises:
a first acquisition module for acquiring information about a to-be-measured vehicle;
a second acquisition module for acquiring and displaying a measured item associated with the information about the to-be-measured vehicle;
a receiving module for receiving a user selection operation on the measured item to obtain a selected measured item;
a third acquisition module for acquiring and displaying measurement guidance information corresponding to the selected measured item to prompt a user to connect the vehicle inspection system to the measured item according to the measurement guidance information; and
a display module for measuring the selected measured item, and displaying a signal waveform corresponding to the measured item when a measurement start instruction of a user is received.

11. A vehicle inspection device, **characterized by** comprising: a processor, a memory, a communication interface, and a communication bus, wherein the processor, the memory, and the communication interface communicate with each other via the communication bus;
the memory is used for storing at least one executable instruction that causes the processor to perform the operations of the vehicle inspection method of any one of claims 1-9.
